# FASCICULE DE BREVET EUROPEEN

(11) **EP 2 047 476 B1**
(45) Date de publication et mention de la délivrance du brevet: **22.12.2010**
(21) Numéro de dépôt: 07823614.8
(22) Date de dépôt: 20.07.2007
(51) Int. Cl.: G11C 27/02

(54) **CIRCUIT DE RETENTION DE CHARGES POUR MESURE TEMPORELLE**
LADUNGSZURÜCKHALTUNGSSCHALTUNG ZUR ZEITMESSUNG
CHARGE RETENTION CIRCUIT FOR TIME MEASUREMENT

(30) Priorité: 27.07.2006 FR 0653135
(43) Date de publication de la demande: 15.04.2009
(73) Titulaire: STMicroelectronics SA, 92120 Montrouge (FR)
(72) Inventeur: LA ROSA, Francesco, F-13790 Rousset (FR)
(74) Mandataire: de Beaumont, Michel
(86) Numéro de dépôt international: PCT/FR2007/051696
(87) Numéro de publication internationale: WO 2008/012459

(56) Documents cités:
- EP-A2- 1 473 736
- WO-A-95/06905
- US-A- 3 919 699
- US-B1- 6 185 125
- US-B1- 6 834 009
- US-B1- 6 834 009

## Description

### Domaine de l'invention

La présente invention concerne de façon générale les circuits électroniques et, plus particulièrement, la réalisation d'un circuit permettant de retenir des charges électriques de façon contrôlable pour une mesure temporelle.

### Exposé de l'art antérieur

Dans de nombreuses applications, on souhaite disposer d'une information représentative d'un temps écoulé entre deux événements, qu'il s'agisse d'une mesure précise ou approximative. Un exemple d'application concerne la gestion temporelle de droits d'accès notamment à des médias.

L'obtention de cette information représentative du temps écoulé requiert classiquement une mesure temporelle par un circuit électronique alimenté, par exemple au moyen d'une batterie, afin de ne pas perdre l'évolution de l'information lorsque le circuit n'est pas utilisé.

Il serait souhaitable de disposer d'une mesure temporelle qui fonctionne même lorsque le circuit électronique de mesure n'est pas alimenté.

La demande internationale WO-A-03/083769 décrit une entité électronique transactionnelle sécurisée par mesure du temps, dans laquelle le temps qui s'écoule entre deux transactions successives est déterminé en mesurant la charge d'un composant capacitif présentant une fuite de son espace diélectrique. Le composant est chargé lorsque le circuit est alimenté et sa charge résiduelle, après une interruption de l'alimentation, est mesurée lorsque le circuit est de nouveau alimenté. Cette charge résiduelle est considérée comme représentative du temps écoulé entre les deux instants d'alimentation du circuit.

L'entité électronique est basée sur un transistor MOS dont la grille est connectée à une première électrode d'un composant capacitif dont l'autre électrode est reliée à la masse avec la source du transistor. Le drain du transistor est connecté à une tension d'alimentation au moyen d'une résistance de conversion courant-tension. La tension mesurée aux bornes de la résistance est fonction du courant de drain dans le transistor, donc de sa tension grille-source, donc de la tension aux bornes du composant capacitif. Un intervalle temporel est initialisé en chargeant le composant capacitif par application d'une source d'énergie électrique sur son électrode commune à la grille du transistor.

La solution proposée par ce document présente plusieurs inconvénients.

Tout d'abord, la plage temporelle mesurable est limitée par les possibilités d'intervention sur le diélectrique du composant capacitif.

Ensuite, la charge du composant capacitif engendre une contrainte électrique sur son diélectrique (stress) de sorte que les mesures dérivent dans le temps.

Par ailleurs, la structure proposée requiert la réalisation d'un composant spécifique. Dans certaines applications, il serait souhaitable d'associer l'élément de mesure temporelle à une mémoire pour conditionner l'accès aux données ou programmes contenus dans cette mémoire. La solution connue du document susmentionné est difficilement compatible avec les étapes de fabrication des mémoires.

En outre, l'interprétation de la charge résiduelle dans le composant capacitif nécessite des étapes de calibration pour générer des tables de conversion charge-temps.

Le document US-A-3919699 décrit un circuit de mémorisation dans lequel un premier élément capacitif est connecté à la grille d'un transistor à effet de champ et un deuxième élément capacitif est connecté, par l'intermédiaire d'un interrupteur, à cette grille.

Le document US-B-6834009 divulgue un circuit de rétention de charges comme indiqué dans le preambule de la revendication 1. Il décrit un circuit électronique formant un commutateur reprogrammable non volatile dans lequel deux transistors MOS sont interconnectés à la grille d'un troisième.

### Résumé de l'invention

La présente invention vise à pallier tout ou partie des inconvénients des solutions connues pour fournir une information représentative d'un temps écoulé entre deux événements, sans qu'il soit nécessaire que le circuit électronique contenant les moyens pour y parvenir soit alimenté en permanence.

Selon un premier aspect, la présente invention vise un circuit électronique de rétention de charges pour une mesure temporelle.

Selon un deuxième aspect, l'invention vise la réalisation d'un tel circuit compatible avec les technologies utilisées pour la réalisation de cellules mémoire.

Selon un troisième aspect, la présente invention vise la lecture d'un circuit électronique de rétention de charges sans contrainte de table de conversion d'une valeur de charge résiduelle en intervalle temporel.

Selon un quatrième aspect, l'invention vise une programmation rapide d'un circuit électronique de rétention de charges.

Pour atteindre ces objets, la présente invention prévoit un circuit électronique de rétention de charges pour une mesure temporelle comme définit par la revendication 1.

Selon un mode de réalisation de la présente invention, la mesure d'une information temporelle est obtenue en évaluant la charge résiduelle du noeud flottant à partir du courant dans le premier transistor.

Selon un mode de réalisation de la présente invention, l'épaisseur de l'espace diélectrique du deuxième élément capacitif est supérieure à celle du premier.

Selon un mode de réalisation de la présente invention, au moins un troisième élément capacitif a une première électrode reliée audit noeud flottant et une deuxième électrode connectable à une source de tension.

Selon un mode de réalisation de la présente invention, une réinitialisation ou programmation est obtenue en injectant ou extrayant des charges du noeud flottant par l'intermédiaire du troisième élément capacitif.

Selon un mode de réalisation de la présente invention, l'épaisseur de l'espace diélectrique du troisième élément capacitif est supérieure à celle du premier.

Selon un mode de réalisation de la présente invention, ledit troisième élément capacitif est formé par un diélectrique entre une grille flottante et la zone active d'un transistor à double grille.

Selon un mode de réalisation de la présente invention, ledit premier transistor est un transistor à grille flottante.

Selon un mode de réalisation de la présente invention, l'épaisseur de l'espace diélectrique entre la grille flottante et la zone active du premier transistor est supérieure à celle de l'espace diélectrique du troisième élément capacitif.

Selon un mode de réalisation de la présente invention, la capacité du deuxième élément conditionne le temps de rétention.

L'invention prévoit également un procédé de commande d'un circuit de rétention de charges, dans lequel une programmation ou initialisation est obtenue en injectant ou extrayant des charges sur le noeud flottant.

### Brève description des dessins

Ces objets, caractéristiques et avantages de la présente invention seront exposés en détail dans la description suivante de modes de mise en oeuvre et de réalisation particuliers faite à titre non-limitatif en relation avec les figures jointes parmi lesquelles :
la figure 1 représente, de façon très schématique et sous forme de blocs, une entité électronique équipée d'un circuit de rétention de charges selon un aspect de la présente invention ;
la figure 2 représente un mode de réalisation d'un circuit électronique de rétention de charges selon le premier aspect de l'invention ;
la figure 3 est un graphe courant-tension illustrant le fonctionnement du circuit de la figure 2 ;
la figure 4 est un chronogramme illustrant le fonctionnement du circuit de la figure 2 ;
la figure 5 représente un deuxième mode de réalisation d'un circuit de rétention de charges selon le premier aspect de l'invention ;
la figure 6 est un graphe courant-tension illustrant le fonctionnement du circuit de la figure 5 ;
la figure 7 représente une variante du circuit de la figure 5 dans un exemple d'environnement ;
les figures 8A, 8B et 8C sont respectivement une vue de dessus, une vue en coupe selon une première direction et le schéma électrique équivalent d'un mode de réalisation d'un circuit électronique de rétention de charges selon le deuxième aspect de la présente invention ;
les figures 9A, 9B et 9C sont respectivement une vue de dessus, une vue en coupe selon une deuxième direction et le schéma électrique équivalent d'un premier élément du circuit des figures 8A à 8C ;
les figures 10A, 10B et 10C sont respectivement une vue de dessus, une vue en coupe selon la deuxième direction et le schéma électrique équivalent d'un deuxième élément du circuit des figures 8A à 8C ;
les figures 11A, 11B et 11C sont respectivement une vue de dessus, une vue en coupe selon la deuxième direction et le schéma électrique équivalent d'un troisième élément du circuit des figures 8A à 8C ;
les figures 12A, 12B et 12C sont respectivement une vue de dessus, une vue en coupe selon la deuxième direction et le schéma électrique équivalent d'un quatrième élément du circuit des figures 8A à 8C ;
la figure 13 représente un premier mode de réalisation d'un circuit de lecture d'un circuit électronique de rétention de charges selon le troisième aspect de la présente invention ;
la figure 14 représente partiellement un deuxième mode de réalisation d'un circuit de lecture d'un circuit de rétention de charges selon le troisième aspect de la présente invention ;
la figure 15 représente un exemple de convertisseur numérique-analogique non linéaire utilisable dans un circuit de lecture selon le troisième aspect de la présente invention ;
les figures 16A et 16B sont des chronogrammes illustrant un mode de fonctionnement d'un circuit de lecture selon le troisième aspect de la présente invention ;
les figures 17A et 17B sont des chronogrammes illustrant une variante du troisième aspect de la présente invention ;
les figures 18A et 18B sont des chronogrammes illustrant un mode de mise en oeuvre d'un procédé de caractérisation d'un circuit de lecture selon le troisième aspect de la présente invention pour un premier exemple de circuit de rétention de charges ;
les figures 19A et 19B sont des chronogrammes illustrant le mode de mise en oeuvre du procédé de caractérisation du circuit de lecture pour un deuxième exemple de circuit de rétention de charges ;
la figure 20 représente, partiellement et schématiquement, une variante du circuit de lecture compatible avec le procédé de caractérisation des figures 18A, 18B, 19A et 19B ; et
la figure 21 représente un mode de réalisation d'un circuit de rétention de charges dans un exemple d'environnement selon le quatrième aspect de la présente invention.

De mêmes éléments ont été désignés par de mêmes références aux différentes figures qui ont été tracées sans respect d'échelle. Par souci de clarté, seuls les éléments utiles à la compréhension de l'invention ont été représentés et seront décrits. En particulier, l'utilisation faite de l'information temporelle obtenue par le circuit selon l'un quelconque des aspects de l'invention n'a pas été détaillée, l'invention étant compatible avec toute exploitation classique d'une telle information temporelle. De même, les procédés et éléments à l'origine d'une programmation ou initialisation de décompte temporel n'ont pas été détaillés, l'invention étant là encore compatible avec tout besoin de déclenchement d'un décompte temporel.

### Description détaillée

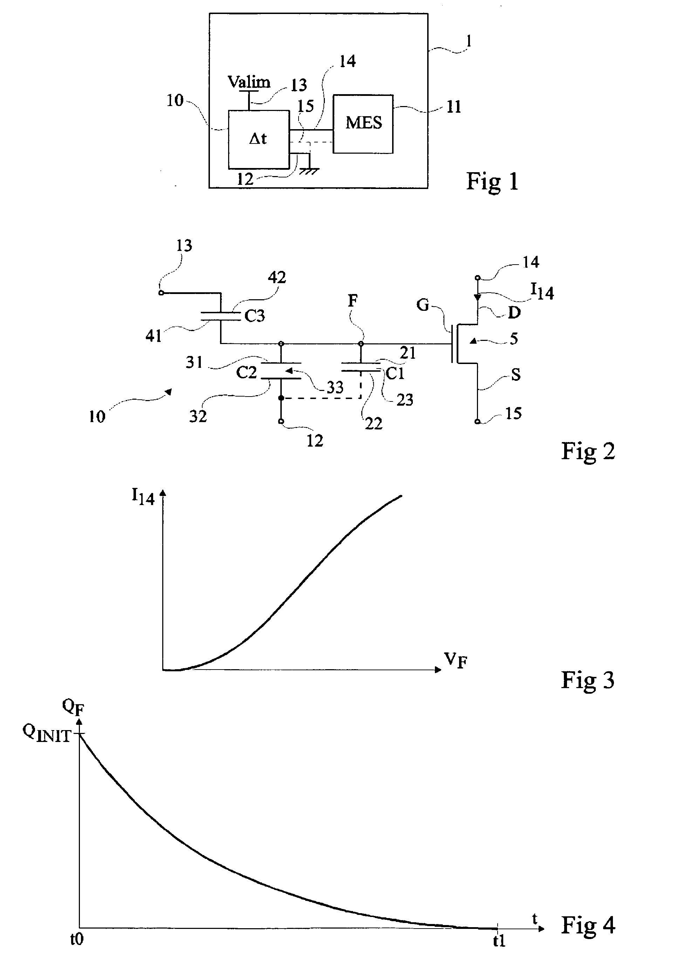

La figure 1 représente, de façon très schématique et sous forme de blocs, un dispositif électronique 1 comportant un circuit électronique de rétention de charges 10 selon l'un quelconque des aspects de la présente invention.

Le dispositif 1 est un dispositif électronique quelconque susceptible d'exploiter une information représentative d'un temps écoulé entre deux événements. Il est équipé d'un circuit électronique 10 (Δt) de rétention de charges contrôlable pour une mesure temporelle. Ce circuit 10 est susceptible d'être soumis à une tension d'alimentation Valim appliquée entre deux bornes 13 et 12, la borne 12 étant reliée à un potentiel de référence (par exemple, la masse). La tension Valim sert à initialiser une phase de rétention de charges. Deux bornes 14 et 15 du circuit 10 sont destinées à être reliées à un circuit de mesure 11 (MES) capable de transformer une information sur une charge résiduelle d'un élément du circuit 10 en une information relative au temps écoulé entre l'instant d'initialisation de la phase de rétention et l'instant de mesure. La borne 15 peut servir de référence à la mesure et être connectée à la masse.

Le circuit 10 est préférentiellement réalisé en circuit intégré à partir d'un substrat semiconducteur, par exemple en silicium.

La figure 2 représente le schéma électrique d'un premier mode de réalisation d'un circuit 10 de rétention de charges contrôlable selon le premier aspect de la présente invention.

Ce circuit 10 comporte un premier élément capacitif C1 dont une première électrode 21 est connectée à un noeud flottant F et dont l'espace diélectrique 23 est conçu (par sa permittivité et/ou par son épaisseur) pour présenter des fuites non négligeables dans le temps. Par noeud flottant F, on entend un noeud non directement connecté à une quelconque région diffusée du substrat semiconducteur et, plus particulièrement, séparé, par un espace diélectrique, de toute borne d'application de potentiel. Par défaut, la deuxième électrode 22 de l'élément capacitif C1 est soit reliée (pointillé en figure 2) à la borne 12 destinée à être connectée à un potentiel de référence, soit laissée en l'air.

Un deuxième élément capacitif C2 a une première électrode 31 connectée au noeud F et une deuxième électrode 32 connectée à la borne 12. L'espace diélectrique 33 de l'élément capacitif C2 présente une capacité de rétention de charges supérieure à celle de l'élément capacitif C1.

De préférence, un troisième élément capacitif C3 a une première électrode 41 connectée au noeud F et une deuxième électrode 42 reliée à la borne 13 du circuit destinée à être connectée à une source d'alimentation (par exemple la tension Valim) lors d'une initialisation d'une phase de rétention de charges.

Un rôle de l'élément capacitif C2 est de stocker une charge électrique. Un rôle de l'élément capacitif C1 est de décharger relativement lentement l'élément de stockage C2 (par rapport à une connexion directe de son électrode 31 à la masse) grâce à la fuite à travers son espace diélectrique. La présence de l'élément capacitif C2 permet de dissocier le niveau de charge présent dans le circuit par rapport à l'élément de décharge (capacité C1). L'épaisseur du diélectrique de l'élément C2 est supérieure à celle de l'élément C1. La capacité de l'élément C2 est supérieure, de préférence dans un rapport d'au moins 10, à celle de l'élément C1.

Un rôle de l'élément capacitif C3 est de permettre une injection de charges dans l'élément capacitif C2 par effet Fowler-Nordheim ou par un phénomène d'injection d'électrons chauds. L'élément C3 permet d'éviter les contraintes (stress) sur l'élément C1 lors de la charge des éléments C2 et C1 en parallèle. L'épaisseur de l'espace diélectrique de l'élément C3 est supérieure à celle de l'élément C1, de façon à éviter d'introduire un chemin de fuite parasite.

Le noeud F est relié à une grille G d'un transistor à borne de commande isolée (par exemple, un transistor MOS 5), dont les bornes de conduction (drain D et source S) sont connectées à des bornes de sortie 14 et 15 pour mesurer la charge résiduelle contenue dans l'élément C2 (en négligeant la capacité de l'élément C1 en parallèle). Par exemple, la borne 15 est reliée à la masse et la borne 14 est reliée à une source de courant permettant une conversion courant-tension du courant de drain I₁₄ dans le transistor 5.

L'épaisseur du diélectrique de grille du transistor 5 est supérieure à celle du diélectrique de l'élément C1 de façon à éviter d'introduire une fuite supplémentaire sur le noeud F. De préférence, l'épaisseur de grille du transistor 5 est même supérieure à l'épaisseur du diélectrique de l'élément C3, de façon à éviter d'introduire un chemin parasite de programmation (d'injection ou d'extraction de charges du noeud F).

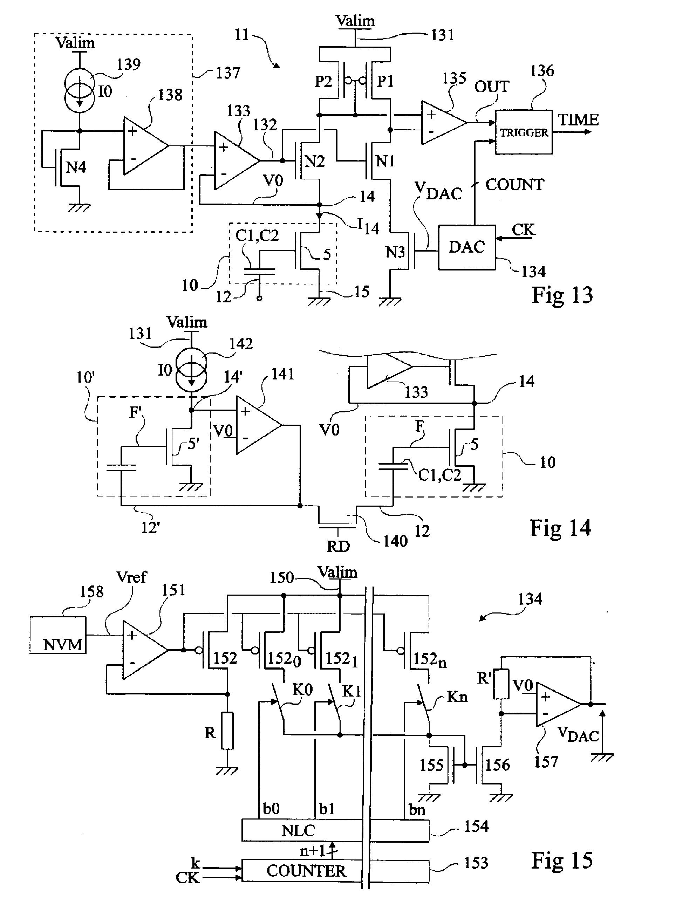

La figure 3 représente un exemple d'allure du courant I₁₄ de drain du transistor 5 en fonction de la tension V_{F} au noeud F, référencée par rapport à la borne 15. La tension V_{F} exprime alors la tension grille-source du transistor 5. Elle dépend de la charge résiduelle aux bornes des capacités C1 et C2 en parallèle, donc essentiellement de la charge résiduelle dans la capacité C2. L'évaluation du courant de drain I₁₄ peut être effectuée en maintenant les bornes 12 et 15 au même potentiel (par exemple, la masse) et en appliquant une tension connue sur la borne 14. On peut également appliquer des potentiels de référence différents sur les bornes 12 et 15 comme on le verra par la suite en relation avec les figures 13 et 14.

La figure 4 illustre l'évolution de la charge Q_{F} au point F en fonction du temps. A un instant t0 où la tension Valim cesse d'être appliquée sur la borne 13, la charge Q_{F} part d'une valeur initiale Q_{INIT} pour s'annuler à un instant t1 avec une allure de décharge capacitive. L'intervalle de temps entre les instants t0 et t1 dépend non seulement de la capacité de fuite du diélectrique de l'élément C1 mais également de la valeur (donc de la capacité de stockage) de l'élément C2 qui conditionne la valeur Q_{INIT}.

En supposant que les bornes 12, 15 et la deuxième électrode 22 de l'élément capacitif C1 sont à des potentiels de référence et que la borne 14 est polarisée à un niveau déterminé pour qu'une variation du courant I₁₄ ne provienne que d'une variation du potentiel du noeud F, cette variation ne dépend alors que du temps écoulé depuis l'instant t0.

Un tel résultat peut être obtenu grâce à la dissociation opérée entre l'élément de fuite temporelle (C1) et l'élément représentatif de la charge résiduelle (C2).

La programmation ou réinitialisation du circuit à travers l'élément capacitif C3 protège l'élément capacitif C1 dont l'épaisseur d'oxyde (diélectrique) est relativement mince et qui risquerait autrement d'être détérioré lors de la programmation. Cela permet notamment de rendre les mesures fiables et reproductibles dans le temps.

Le cas échéant, plusieurs éléments capacitifs C3 sont connectés en parallèle entre la borne 13 et le noeud F de façon à accélérer le temps de programmation ou de réinitialisation.

De même, la durée de rétention peut être adaptée non seulement en réglant les épaisseurs et/ou les permittivités des diélectriques des éléments C1 et C2 mais également en prévoyant plusieurs éléments C1 et/ou C2 en parallèle.

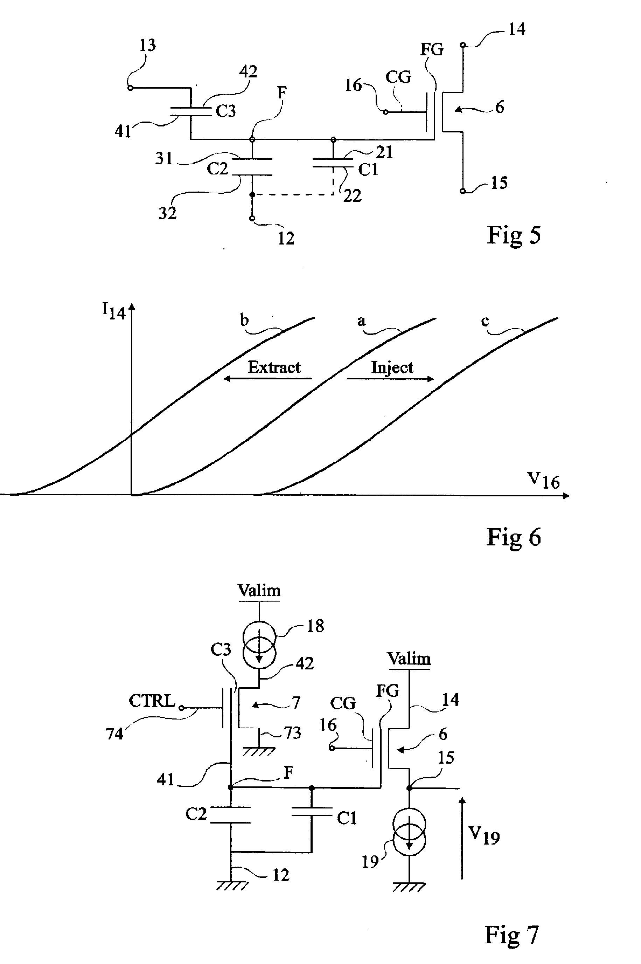

La figure 5 représente un deuxième mode de réalisation d'un circuit selon la présente invention. Par rapport au mode de réalisation de la figure 2, le transistor 5 est remplacé par un transistor 6 à grille flottante FG reliée au noeud F. La grille de commande CG du transistor 6 est reliée à une borne 16 de commande en lecture de la charge résiduelle dans le circuit.

La figure 6 illustre, par un graphe du courant I₁₄ en fonction de la tension V₁₆ appliquée sur la grille de commande, le fonctionnement du circuit de la figure 5. On suppose que la tension aux bornes 14 de drain et 15 de source du transistor 6 est maintenue constante par un circuit de lecture extérieur (11, figure 1). La chute de tension entre la grille flottante et la borne 15 dépend alors de la charge électrique présente au noeud F, de la capacité totale entre les noeuds F et 12 (essentiellement les capacités C1 et C2), et de la tension appliquée sur la grille de commande 16 du transistor 6. En figure 6, trois courbes a, b et c ont été illustrées. La courbe a représente le cas où le noeud F est entièrement déchargé. La courbe b représente le cas d'une charge positive présente sur le noeud F (extraction d'électrons). Le seuil du transistor 6 est alors abaissé. La courbe c représente le cas d'une charge négative au noeud F (injection d'électrons) qui engendre un seuil supérieur pour le transistor MOS.

Selon les applications, on pourra injecter ou extraire des charges du noeud F de façon à modifier la caractéristique du transistor 6 depuis la courbe a vers l'une des courbes b et c. Une fois isolée de la tension de programmation, la fuite de la capacité C1 permet de retrouver avec le temps la courbe a.

L'épaisseur du diélectrique, entre la grille flottante FG et le canal (zone active) du transistor 6, est supérieure à celle de l'élément C1 et préférentiellement supérieure à celle de l'élément C3.

La figure 7 représente le schéma électrique d'une variante selon laquelle l'élément C3 d'injection ou d'extraction de charges est un transistor MOS 7 à grille flottante. Dans l'exemple de la figure 7, le circuit a été représenté relié dans une partie de son environnement. Par exemple, le drain 42 du transistor 7 est relié à une source de courant 18 recevant la tension Valim et sa source 73 est connectée à la masse. Sa grille de commande 74 reçoit un signal de commande CTRL destiné à rendre le transistor 7 passant lors d'un besoin d'injection de charges. La grille flottante 41 du transistor 7 est reliée au noeud F. Le drain (borne 14) du transistor 6 reçoit la tension d'alimentation Valim et sa source est reliée à la masse par une source de courant 19. La tension V₁₉ aux bornes de la source de courant 19 est représentative de la tension au point F.

La variante de la figure 7 fournit une structure permettant l'injection d'électrons sur le noeud F par un phénomène dit de porteurs (électrons) chauds en appliquant des tensions adaptées entre les bornes 42, 73 et 74.

Par la suite, on suppose une extraction d'électrons (application sur la borne 13 d'une tension de réinitialisation positive par rapport à la borne 12) par effet Fowler-Nordheim, mais le fonctionnement qui va être décrit se transpose sans difficulté à une injection d'électrons au noeud F par exemple, par un phénomène dit de porteurs chauds.

Il ressort de la description qui précède qu'il est possible de définir une corrélation entre la charge résiduelle (par rapport à la charge initiale) et le temps passé après une phase de réinitialisation du circuit.

N'importe quel circuit de lecture du potentiel du noeud F peut être envisagé. Par exemple, la valeur mesurée du courant dans le transistor 5 (ou 6) ou d'une tension représentative de ce courant peut être convertie en temps à partir d'une table de conversion ou, après numérisation, d'une loi de conversion établie à partir d'une caractérisation du circuit. Un exemple préféré de circuit de lecture pour interpréter la décharge temporelle sera décrit en relation avec les figures 13 à 19B.

Bien que l'on ait fait référence à une seule tension d'alimentation Valim, des tensions différentes peuvent être utilisées en programmation et en lecture à condition de disposer d'une référence exploitable entre la charge résiduelle et la mesure.

Selon un exemple particulier de réalisation, un circuit de rétention de charges selon le premier aspect de l'invention est réalisé avec les valeurs suivantes :
capacité C1 : 2 fF, épaisseur de diélectrique : 40 angströms ;
capacité C2 : 20 fF, épaisseur de diélectrique : 160 angströms ; et
capacité C3 : 1 fF, épaisseur de diélectrique : 80 angströms.

Un tel circuit initialisé par application d'une tension de l'ordre de 12 volts est déchargé au bout d'environ une semaine. Il ne s'agit bien entendu que d'un exemple, les valeurs des épaisseurs de diélectrique, les constantes diélectriques et l'éventuelle association en parallèle de plusieurs éléments C1 ou C2 conditionnant la durée de rétention des charges.

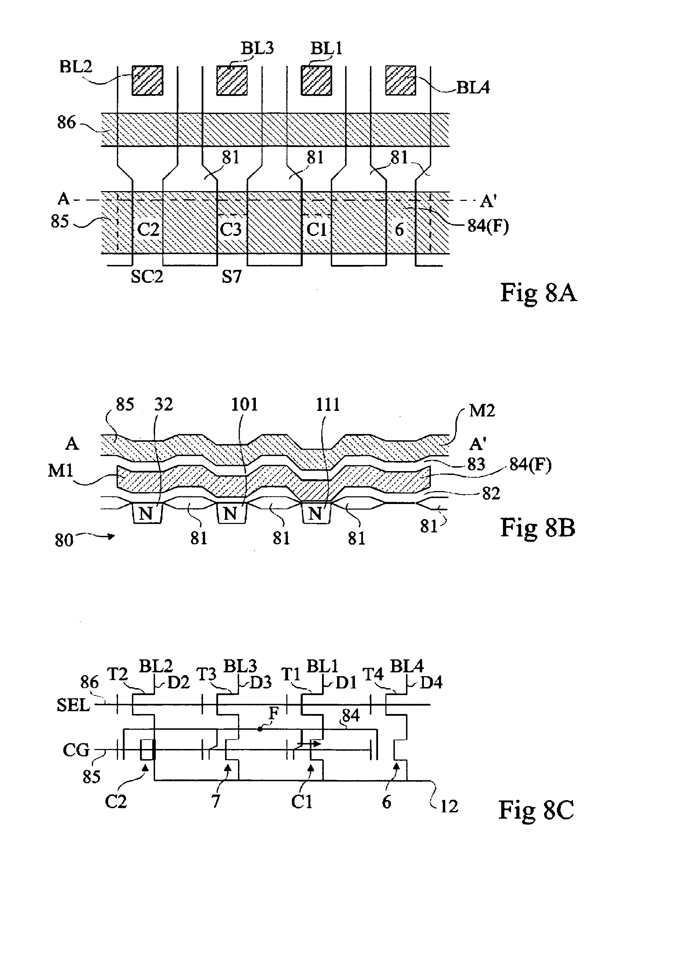

Les figures 8A, 8B, 8C, 9A, 9B, 9C, 10A, 10B, 10C, 11A, 11B, 11C, 12A, 12B et 12C représentent une réalisation d'un circuit selon le mode de réalisation de la figure 7 dans une structure intégrée dérivée d'une architecture de mémoire EEPROM, selon le deuxième aspect de la présente invention.

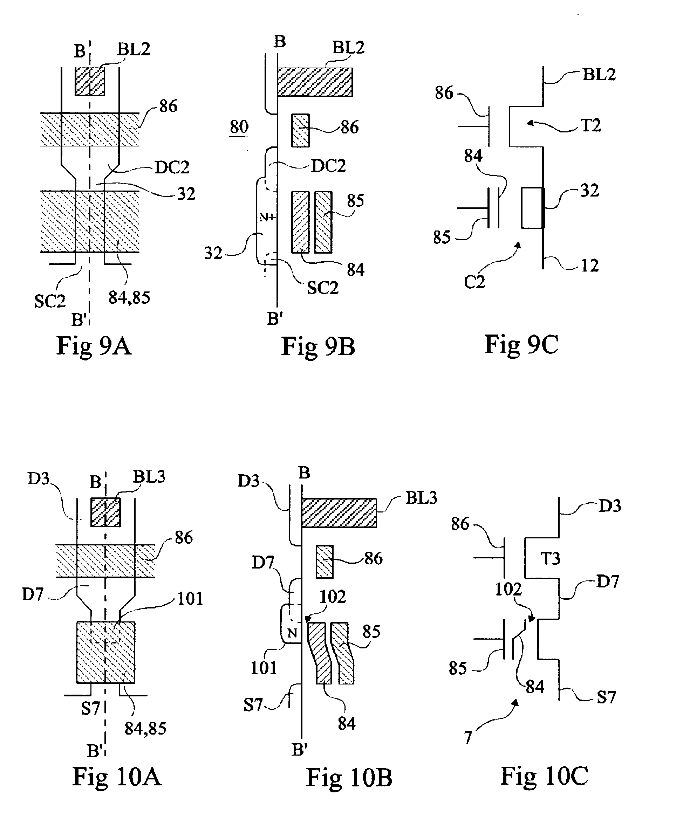

Les figures 8A, 9A, 10A, 11A et 12A sont des vues de dessus schématiques, respectivement du circuit électronique de rétention de charges et de ses éléments C2, 7, C1 et 6. La figure 8B est une coupe selon la ligne AA' de la figure 8A. Les figures 9B, 10B, 11B et 12B sont respectivement des vues en coupe selon les lignes BB' des figures 9A, 10A, 11A et 12A. Les figures 8C, 9C, 10C, 11C et 12C représentent les schémas électriques équivalents respectifs du circuit électronique de rétention de charges et de ses éléments C2, 7, C1 et 6.

Dans l'exemple décrit, on suppose une réalisation de transistors à canal N dans un substrat de silicium de type P. L'inverse est bien entendu possible.

Chaque élément ou cellule C2, 7, C1 ou 6 est obtenu à partir d'un transistor à grille flottante connecté en série avec un transistor de sélection T2, T3, T1 ou T4 à simple grille pour sélectionner, par exemple dans un réseau matriciel de cellules mémoire EEPROM, le circuit électronique de rétention de charges.

Les grilles flottantes des différents transistors constitutifs des éléments C2, 7, C1 et 6 sont interconnectées (ligne conductrice 84) pour former le noeud flottant F. Leurs grilles de commande sont reliées ensemble à une ligne conductrice 85 d'application du signal CG de commande en lecture. Leurs sources respectives sont interconnectées à la borne 12 (la masse) et leurs drains respectifs sont reliés aux sources respectives des transistors de sélection T2, T3, T1 et T4.

Les grilles des transistors T1 à T4 sont reliées ensemble à une ligne conductrice 86 d'application d'un signal SEL de sélection du circuit. Leurs drains respectifs D1 à D4 sont connectés à des lignes de bit BL1 à BL4 commandables individuellement. L'ordre des lignes de bit dans la figure 8C a été illustré de façon arbitraire BL2, BL3, BL1 et BL4 mais l'ordre des différents éléments C2, 7, C1 et 6 dans la direction horizontale des rangées (dans l'orientation des figures) est indifférent.

Dans cet exemple de réalisation, on suppose des régions de source et drain de type N (figure 8B) séparées les unes des autres dans la direction des lignes par des zones isolantes 81. Les grilles flottantes sont réalisées dans un premier niveau conducteur M1 séparé des régions actives par un niveau isolant 82 et les grilles de commande sont réalisées dans un deuxième niveau conducteur M2 séparé du premier par un troisième niveau isolant 83. Les grilles des transistors de sélection sont réalisées, par exemple, dans le niveau M1.

Une différence par rapport à un réseau de cellules mémoire EPROM classique est que les grilles flottantes sont interconnectées par groupe de quatre transistors pour réaliser le noeud flottant F. Une autre différence est que les transistors à grille flottante réalisant les différents éléments du circuit sont différents les uns des autres dans l'épaisseur de leur fenêtre tunnel et/ou dans leur connexion de drain et source.

Les figures 9A à 9C illustrent la réalisation du condensateur C2 de stockage. Les drain DC2 et source SC2 du transistor à grille flottante correspondant sont court-circuités (par extension de l'implantation de type N+ dans toute la zone active, figure 9B) pour former l'électrode 32 du condensateur. Par ailleurs, la fenêtre tunnel est éliminée par rapport à une cellule EEPROM standard.

Les figures 10A à 10C illustrent la réalisation du transistor 7 formant l'élément capacitif C3 de programmation. Il s'agit d'une cellule EEPROM standard dont l'extension 101 de la zone dopée N sous la fenêtre tunnel 102 (figure 10B) permet d'obtenir un plateau dans la zone d'injection de charges. A la manière d'une cellule EEPROM standard, la zone de drain D7 est reliée à la source du transistor de sélection T3. La zone de source S7 est reliée à la borne 12.

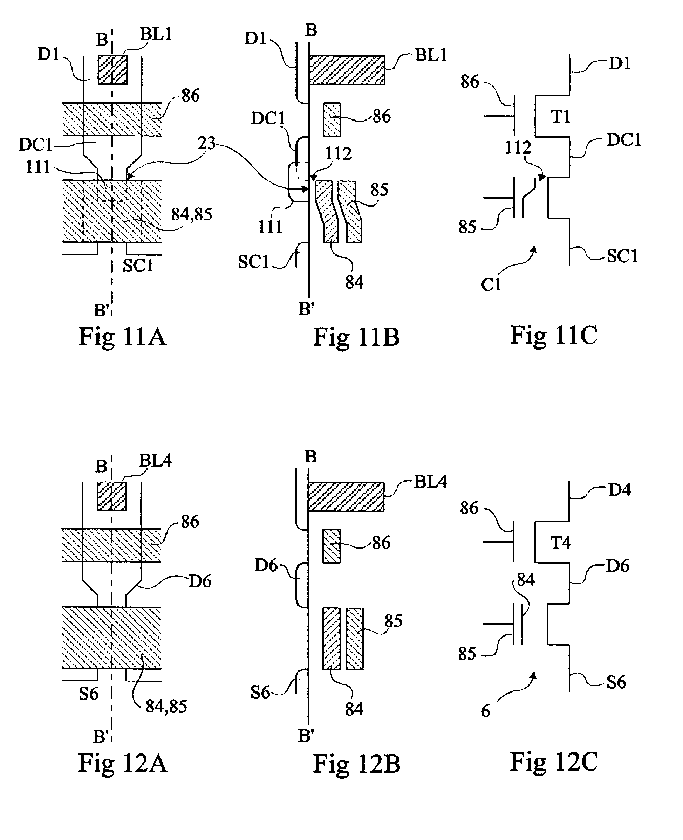

Les figures 11A, 11B et 11C illustrent la réalisation de l'élément capacitif C1 constituant l'élément de fuite du circuit de rétention de charges. Par rapport à une cellule EEPROM standard, une différence consiste à amincir (zone 112, figure 11B) la fenêtre diélectrique servant à l'effet tunnel pour augmenter les fuites. Par exemple, l'épaisseur du diélectrique 112 est choisie pour être d'environ la moitié (par exemple entre 30 et 40 angströms) de celle (par exemple entre 70 et 80 angströms) d'une fenêtre tunnel (102, figure 10B) d'une cellule non modifiée.

Les figures 12A, 12B, 12C illustrent la réalisation du transistor de lecture 6 dans lequel la fenêtre tunnel a été supprimée de même que, de préférence, la zone implantée habituelle (101, figure 10B) d'une cellule EEPROM. La zone active limitée par les source S6 et drain D6 est donc similaire à celle d'un transistor MOS normal.

Les représentations des figures 8A à 12C sont schématiques et pourront être adaptées à la technologie utilisée. En particulier, les grilles ont été représentées alignées avec les limites des zones de drain et source mais un léger recouvrement est souvent présent.

Un avantage de la réalisation au moyen d'une technologie de cellules EEPROM est que le circuit de rétention de charges peut être programmé et réinitialisé en appliquant les mêmes niveaux de tension et les mêmes fenêtres temporelles que ceux utilisés pour effacer ou écrire dans des cellules mémoire EEPROM.

Un autre avantage est que cela préserve une stabilité dans le temps en évitant les dégradations de l'oxyde mince de l'élément de fuite (C1) lors des opérations d'écritures successives.

Les connexions respectives des lignes de bit BL1 à BL4 dépendent des phases de fonctionnement du circuit et notamment de la phase de programmation (réinitialisation) ou de lecture.

Le tableau I ci-dessous illustre un mode de mise en oeuvre d'une réinitialisation (SET) et d'une lecture (READ) d'un circuit électronique de rétention de charges tel qu'illustré par les figures 8A à 12C.

**Tableau I**

| | SEL | CG | BL2 | BL3 | BL1 | BL4 | 12 |
|---|---|---|---|---|---|---|---|
| SET | VPP₁ | 0 | HZ | VPP₂ | HZ | HZ | HZ |
| READ | V_{SEL} | V_{READ} | HZ | HZ | HZ | V₁₄ | 0 |

Dans une phase de réinitialisation SET, le signal de sélection SEL est porté à un premier potentiel haut VPP₁ par rapport à la masse pour rendre passants les différents transistors T1 à T4 tandis que le signal CG appliqué sur les grilles de commande des transistors à grille flottante reste au niveau bas 0 de façon à ne pas rendre passant le transistor 6. Les lignes de bit BL1, BL2 et BL4 restent en l'air (état de haute impédance HZ) tandis que la ligne BL3 se voit appliquer un potentiel positif V_{PP2} permettant la charge du noeud flottant F. La ligne 12, commune aux sources des transistors à grille flottante, est préférentiellement laissée en l'air HZ.

Pour la lecture READ, les différents transistors de sélection sont activés par le signal SEL à un niveau V_{SEL} et une tension V_{READ} de lecture est appliquée sur les grilles de commande des différents transistors à grille flottante. Les lignes BL1, BL2 et BL3 sont dans un état de haute impédance HZ alors que la ligne BL4 reçoit un potentiel V₁₄ permettant d'alimenter la source de courant de lecture. La ligne 12 est ici connectée à la masse.

Les relations entre les différents niveaux VPP₁, VPP₂, V_{SEL}, V_{READ} et V₁₄ sont, de préférence, les suivantes :
VPP₁ supérieur à VPP₂ ;
V_{SEL} supérieur à V_{READ} ;
V_{READ} du même ordre de grandeur que V₁₄.
Selon un exemple particulier de réalisation :
VPP₁ = 14 volts ;
VPP₂ = 12 volts ;
V_{SEL} = 4 volts ;
V_{READ} = 2 volts ; et
V₁₄ = 1 volt.

Ce qui a été décrit ci-dessus en relation avec une cellule EEPROM par élément du circuit de rétention de charges peut bien entendu être remplacé par une structure dans laquelle des sous-ensembles de plusieurs cellules identiques en parallèle sont utilisés pour les différents éléments respectifs. En particulier :
plusieurs éléments C2 peuvent être utilisés en parallèle pour accroître la capacité du noeud F de façon à augmenter le temps de décharge du circuit électronique ;
plusieurs éléments 7 peuvent être utilisés en parallèle pour accroître la vitesse d'injection ou d'extraction d'électrons au noeud F lors d'une réinitialisation d'une programmation ;
plusieurs éléments de fuite C1 peuvent être utilisés en parallèle pour réduire le temps de décharge du système ; et/ou
plusieurs éléments de lecture 6 peuvent être introduits en parallèle pour fournir un courant supérieur lors de l'évaluation du circuit.

Un circuit électronique de rétention peut être introduit dans n'importe quelle position d'un réseau de cellules mémoire EEPROM standard, ce qui permet de rendre plus difficile sa localisation par un éventuel utilisateur mal intentionné.

En variante, plusieurs circuits peuvent être placés à différents endroits d'un plan mémoire EEPROM. Dans ce cas, on peut prévoir que tous les circuits aient un même temps de décharge ou des circuits ayant des temps de décharge différents les uns des autres.

Selon une autre variante, plusieurs circuits sont répartis dans le plan mémoire mais un seul est utilisé à la fois, selon une séquence déterminée ou aléatoire, contrôlée par un générateur d'adresses.

Le cas échéant, les transistors de sélection des cellules formant le circuit de rétention de charges de l'invention sont partagés avec des cellules EEPROM normales sur les mêmes lignes de bits, pourvu de prévoir des moyens d'adressage et de commutation adaptés.

La figure 13 représente un premier mode de réalisation d'un circuit (11, figure 1) de lecture de l'état d'un circuit électronique de rétention de charges contrôlable pour une mesure temporelle selon le troisième aspect de l'invention. Pour simplifier, le circuit de rétention de charges (figure 2, figure 5, figure 7 ou figures 8A à 12C) a été symbolisé par un bloc 10 contenant le transistor de lecture (dans cet exemple, un transistor MOS 5) et un élément capacitif combinant les éléments C1 et C2.

Plus généralement, selon ce troisième aspect de l'invention, le circuit de rétention de charges pourra être constitué par n'importe quel circuit (par exemple, celui décrit dans la demande internationale WO-A-03/083769 déjà mentionnée).

Le transistor 5 de sortie du circuit 10 est placé dans une première branche d'un montage différentiel comprenant deux branches parallèles de transistors MOS en série entre une borne 131 d'application d'une tension d'alimentation Valim et la masse. Chaque branche comporte, en série, un transistor P1 ou P2 à canal P, un transistor N1 ou N2 à canal N, et un transistor N3 ou N5 à canal N. Les deux transistors P1 et P2 ont leurs grilles reliées à la source du transistor P2 et leurs drains reliés à la borne 131 d'alimentation. Les transistors N1 et N2 ont leurs grilles reliées à une borne 132 d'application d'un potentiel de référence. Ce potentiel de référence est fourni, dans cet exemple, par un amplificateur opérationnel 133 recevant sur une entrée non inverseuse (+) une tension V0 et dont l'entrée inverseuse (-) est reliée à la source du transistor N2 et au drain du transistor N5 (borne 14 du circuit 10). Le montage optionnel 133, N1 et N2 permet de fixer un même niveau de tension sur les sources des transistors N1 et N2. La grille du transistor N3 reçoit un signal analogique V_{DAC} fourni par un convertisseur numérique-analogique 134 dont le fonctionnement sera décrit par la suite. Son rôle est de fournir une tension en escalier pour interpréter la charge résiduelle dans le circuit 10.

Les sources respectives des transistors P2 et P1 sont reliées sur deux entrées, par exemple non inverseuse (+) et inverseuse (-) d'un comparateur 135 dont la sortie OUT sert à déclencher (TRIGGER 136) la fourniture d'un résultat TIME correspondant à un mot binaire représentatif de l'état COUNT d'un compteur du convertisseur. Ce compteur compte au rythme d'une fréquence d'horloge CK pour générer le signal en escalier comme on le verra par la suite.

Le circuit de la figure 13 effectue une comparaison de la différence entre les courants dans les deux branches. La sortie du comparateur 135 bascule quand le courant dans la branche P1, N1 et N3 devient supérieur (ou inférieur selon l'état initial) au courant dans la branche P2, N2 et N5.

Si la borne 12 est connectée à la masse, pour qu'un courant I₁₄ circule dans la première branche, il faut que la quantité Q_{F}/C_{T} soit supérieure à la tension seuil (Vₜ) du transistor 5, où Q_{F} représente la charge résiduelle dans le circuit 10 et C_{T} la valeur cumulée des capacités entre le noeud F et la masse (en particulier les éléments capacitifs C1 et C2).

Le potentiel V0 imposé sur la borne 14 par l'intermédiaire de l'amplificateur 133 provient, de préférence, d'un circuit 137 comportant un amplificateur 138 monté en suiveur (sortie reliée à l'entrée inverseuse (-)) dont l'entrée non inverseuse (+) est reliée au drain d'un transistor N4 à canal N, monté en diode. La source du transistor N4 est reliée à la masse tandis que son drain est relié, par une source de courant constant 139 (10), à une borne d'application d'un potentiel positif d'alimentation (par exemple, Valim).

Le circuit 137 génère un niveau V0 tel que le transistor 5 est conducteur de façon à permettre la lecture.

Le courant 10 est choisi en fonction de la consommation souhaitée pour le circuit.

Les transistors à canal N sont appariés ("matched") pour des questions de précision.

De préférence, on impose sur la borne 12 un niveau supérieur au niveau V0. Un objectif est de faire que, même si la cellule 10 est entièrement déchargée, le transistor 5 conduise et permettre une lecture sur toute la plage de fonctionnement. Ainsi, la sortie du comparateur 135 bascule lorsque la tension V_{DAC} fournie par le convertisseur 134 dépasse le niveau V0 + Q_{F}/C_{T}.

La figure 14 représente un mode de réalisation préféré dans lequel une structure de référence 10' dont le noeud F' est en permanence déchargé sert à fixer le potentiel de la borne 12 du circuit 10. Par exemple, un transistor 140 (Pass Gate) relie les bornes 12 et 12' des circuits 10 et 10'. Un amplificateur 141 a son entrée non inverseuse (+) reliée à la borne 14' du circuit 10' et, par une source de courant constant 142 (10), à la borne 131 d'application de la tension d'alimentation. L'entrée inverseuse (-) de l'amplificateur 141 reçoit le potentiel de référence V0 généré par un circuit 137 tel que décrit en relation avec la figure 13. Les sources de courant 139 et 142 génèrent un même courant 10. Par conséquent, le potentiel de la borne 14' est fixé à V0 (imposé par la contre réaction de l'amplificateur 141 et par la grille du transistor 5' qui est au niveau V0 par le dimensionnement de la source 142). Le potentiel de la borne 12' est supérieur au niveau V0 même si aucune charge n'est stockée au noeud F'. En effet, lorsqu'un potentiel est appliqué sur la borne 12' (par l'amplificateur 141), le noeud F' représente le point milieu d'un diviseur capacitif (ne serait-ce qu'en tenant compte de la capacité de grille du transistor 5' par rapport à la masse). Par conséquent, pour obtenir le niveau V0 au noeud F', le potentiel de la borne 12' est supérieur au niveau V0.

Pour simplifier la description de la figure 14, le reste de la structure, identique à celle exposée en relation avec la figure 13, n'a pas été détaillé.

Le transistor 140 n'est rendu passant qu'en mode lecture du circuit. Le reste du temps, la borne 12 est soit en l'air, soit connectée à la masse.

Lorsque le transistor 140 est passant, le potentiel de la borne 12' est reporté sur la borne 12. Comme le potentiel de la borne 14 est imposé au niveau V0 par l'amplificateur 133 (dont l'entrée non inverseuse est reliée en sortie du circuit 137), le potentiel du noeud F est au niveau V0 majoré de la charge stockée sur ce noeud. Si la cellule 10 n'est pas chargée, le noeud F est au niveau V0. Si la cellule contient une charge Q_{F}, le potentiel du noeud F est égal à V0+Q_{F}/C_{T}.

Un avantage de ce mode de réalisation où le transistor 140 impose la même tension sur les deuxièmes électrodes accessibles des éléments capacitifs des circuits 10 et 10' est de compenser d'éventuelles dispersions de fabrication.

Qu'il s'agisse du circuit de lecture de la figure 13 ou de la figure 14, il peut être éteint au moyen de commutateurs de commande adaptés (par exemple, déconnectant les branches de l'alimentation et/ou éteignant les sources de courant) en dehors de périodes de lecture.

Côté lecture, en supposant que la charge Q_{F} a une valeur initiale Q_{INIT} notée ici Q(r), une tension V_{DAC} en escalier fournie par le convertisseur 134 comprise entre V0 et V0+Q(r)/C_{T} permet de mesurer le temps.

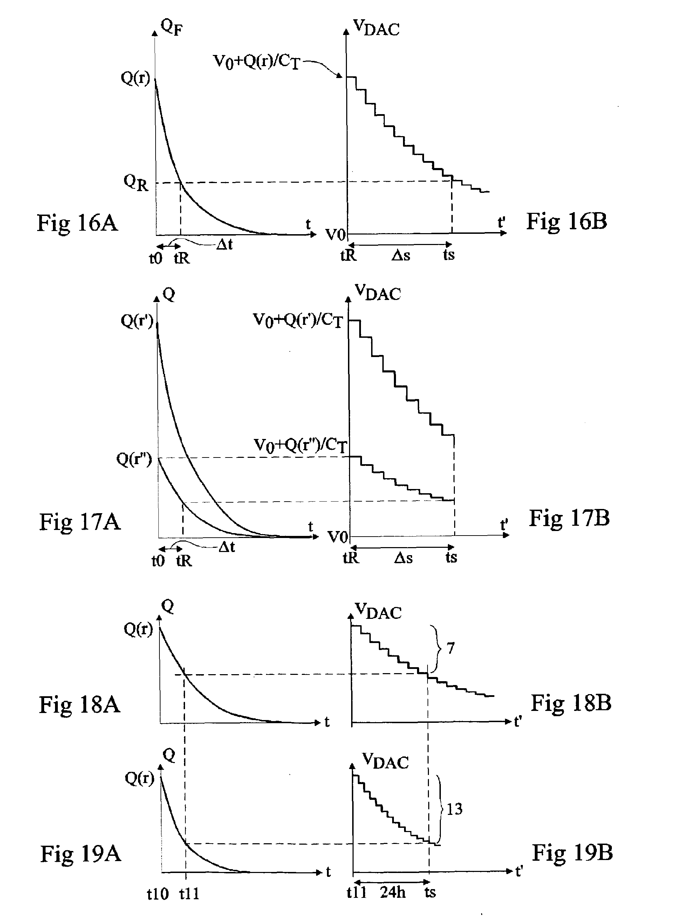

En partant d'un niveau V0+Q(r)/C_{T} et en diminuant progressivement le niveau, le point de basculement du comparateur 135 correspond à une consigne numérique COUNT du convertisseur. Cette consigne est une information sur le temps écoulé depuis la réinitialisation (programmation du circuit de rétention de charges 10) au niveau Q(r). Des exemples seront donnés en relation avec les figures 16A à 19B.

Un avantage est que la fourniture d'un mot numérique est aisément exploitable.

De préférence, le convertisseur numérique-analogique est un convertisseur non linéaire pour compenser l'allure non linéaire (figure 4) de la décharge capacitive du circuit de rétention de charges. En variante, la correction est effectuée en aval par des moyens numériques (de type calculateur) corrigeant le temps écoulé en fonction du compte COUNT auquel le circuit de lecture bascule.

La figure 15 représente un exemple de schéma électrique d'un convertisseur numérique-analogique 134. Une tension de référence V_{ref} est fournie sur un amplificateur différentiel 151 dont la sortie est reliée aux grilles communes de n+2 branches comportant un transistor MOS à canal P 152, 152₀, 152₁, ..., 152ₙ. Un premier transistor 152 a sa source reliée à la masse par une résistance R ainsi qu'à l'entrée inverseuse (-) de l'amplificateur 151 de façon à fixer un courant en V_{ref}/R. Les transistors 152₀ à 152ₙ des n+1 branches suivantes 152₀ à 152ₙ sont de taille croissante d'une branche à la suivante à partir de la taille unitaire du transistor 152₀, égale à celle du transistor 152. Le rapport de taille est de préférence double d'une branche à la suivante pour reproduire le caractère binaire du comptage sur les amplitudes de tension. Les sources respectives des transistors 152 et 152₀ à 152ₙ sont reliées à une borne 150 d'application d'une tension d'alimentation Valim. Les drains respectifs des transistors 152₀ à 152ₙ sont connectés, par des interrupteurs K₀ à Kₙ, au drain d'un transistor MOS à canal N 155 monté en diode et en miroir de courant sur un deuxième transistor à canal N 156. Les sources des transistors 155 et 156 sont connectées à la masse. Le drain du transistor 156 est relié à une entrée inverseuse (-) d'un amplificateur opérationnel 157 dont l'entrée non inverseuse (+) reçoit la tension V0 de référence du circuit de lecture et dont la sortie fournit la tension V_{DAC}. Une résistance R' (par exemple de même valeur que la résistance R) relie la sortie de l'amplificateur 157 à son entrée inverseuse. Les interrupteurs K₀ à Kₙ (par exemple des transistors MOS) sont commandés par les bits respectifs b0, b1, ..., bn d'un circuit de comptage sur n+1 bits. Le circuit de comptage comporte un compteur 153 dont n+1 bits sont envoyés en parallèle sur un circuit de conversion non linéaire 154 (NLC). Les amplificateurs 151 et 157 de même que le compteur 153 et le circuit 154 sont alimentés, par exemple, par la tension Valim.

En supposant les résistances R et R' de même valeur, le courant dans le transistor 156 est égal à k*V_{ref}/R, où k représente l'état COUNT du circuit de comptage. La tension de sortie V_{DAC} est alors donnée par la relation V0 + k*V_{ref}.

D'autres circuits de conversion numérique-analogique non linéaires pourront être utilisés, le circuit de la figure 15 représentant un exemple simple de réalisation d'un tel convertisseur.

Les figures 16A et 16B illustrent un premier mode de fonctionnement d'un circuit de lecture selon le troisième aspect de l'invention et représentent respectivement des exemples d'allure de la charge Q_{F} et de la tension V_{DAC} en fonction du temps.

On suppose une initialisation du circuit de décharge à un niveau Q(r) à un instant t0 et une lecture à un instant t_{R} où la charge résiduelle est Q_{R}.

La non linéarité du convertisseur est définie par le circuit 154 pour compenser la courbe de décharge du circuit de rétention de charges, par exemple, à partir de données expérimentales ou de caractérisation. Le circuit 154 est, par exemple, une logique combinatoire convertissant une croissance linéaire de la sortie du compteur 153 en une croissance non linéaire.

Selon l'instant auquel est effectuée la lecture (par exemple instant t_{R}, figure 16A), le courant dans le transistor 5 engendre un basculement de la sortie OUT avec un retard Δs par rapport à l'instant de début de lecture (origine des temps du chronogramme de la figure 16B). Cet intervalle de temps correspond en fait à un nombre fourni par le compteur 153 dans la génération de la tension en escalier envoyée sur la grille du transistor N3 (figure 13). L'état du compteur à l'instant où le signal OUT bascule permet de déduire l'intervalle de temps écoulé Δt entre l'instant de programmation t0 et l'instant de lecture t_{R}, que le dispositif contenant le circuit de rétention de charges ait été ou non alimenté (pourvu que sa borne 13 soit restée en l'air ou isolée). Dans l'exemple des figures 16A et 16B, on suppose une tension V_{DAC} décroissante depuis le niveau V0+Q(r)/C_{T}. Une mesure par tension croissante est bien entendu possible, le point de basculement tₛ restant le même.

Le rythme des escaliers de la tension V_{DAC} (donc la fréquence CK du compteur 153) est choisi suffisamment rapide par rapport à la vitesse de décharge du circuit 10 pour que l'intervalle Δs entre l'instant de début de lecture t_{R} et l'instant de basculement tₛ soit négligeable par rapport à l'intervalle réel Δt (t_{R}-t₀). L'exagération de la représentation des figures montre cependant l'inverse.

On voit donc que la décharge de l'élément 10 de l'invention peut s'effectuer sans alimentation, sans pour autant perdre la notion temporelle.

La tension V_{ref} est, de préférence, choisie pour satisfaire à l'équation k*V_{ref} = Q(r)/C_{T}.

De préférence, un ajustement du circuit de lecture est effectué en stockant, dans un registre 158 de mémorisation non volatile (NVM), une valeur V_{ref} de tension ou le nombre k de démarrage du compteur obtenu par caractérisation pour satisfaire la relation ci-dessus, et en utilisant cette valeur à chaque lecture.

Les figures 17A et 17B représentent, dans deux états de charge initiaux Q(r') et Q(r") des exemples de décroissance de la charge en fonction du temps et l'ajustement possible effectué avec le convertisseur numérique-analogique non linéaire.

Le fait d'ajuster la valeur de référence (dans cet exemple, respectivement à des valeurs Q(r')/(k*C_{T}) et Q(r")/(k*C_{T}) rend la mesure temporelle indépendante des conditions de programmation, c'est-à-dire de la charge initiale Q(r') ou Q(r"). Comme on peut le voir sur les figures 17A et 17B, l'instant tₛ de basculement est le même alors que les niveaux de démarrage du convertisseur sont différents en étant adaptés aux niveaux de charges initiaux.

Selon que la courbe de décharge est connue ou non, il peut être nécessaire d'étalonner chaque circuit 10 de décharge de façon à ce que la non linéarité du convertisseur 134 suive la courbe de décharge.

Les figures 18A, 18B, 19A et 19B illustrent un mode de mise en oeuvre préféré de l'invention dans lequel un étalonnage du circuit de lecture est effectué lors d'une première utilisation, lors d'une initialisation ou en fin de fabrication. Pour cela, le circuit est programmé à un instant t10 puis mesuré à un instant t11 dont l'intervalle par rapport à l'instant t10 est connu (par exemple, un intervalle de 24 heures). On détermine alors le nombre de marches de la décroissance en escalier fourni par le convertisseur numérique-analogique jusqu'à l'instant de basculement tₛ. Cela permet de définir, pour le circuit concerné, le nombre de pas ou paliers pour l'intervalle de temps connu. Ce nombre peut alors être stocké dans un élément de mémorisation non volatile du dispositif 1.

Les figures 18A et 18B illustrent un premier exemple dans lequel 7 paliers (steps) sont nécessaires pour 24h. L'intervalle de temps (TIME STEP) entre deux paliers est alors de 24/7.

Les figures 19A et 19B illustrent un deuxième exemple dans lequel 13 paliers sont nécessaires pour définir une même plage horaire au moyen d'un autre circuit différent, par exemple, par les valeurs des capacités C1 et C2. L'intervalle de temps entre deux paliers est alors de 24/13.

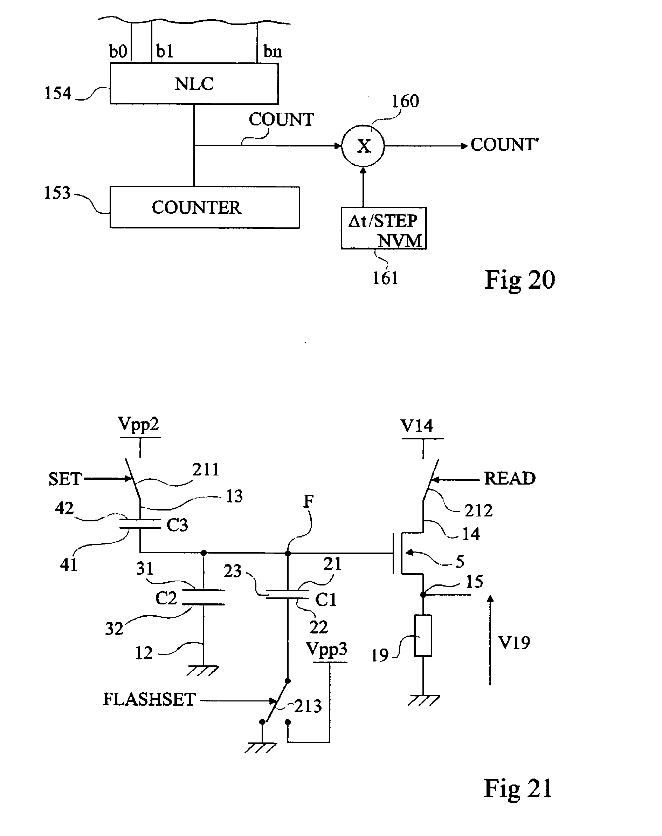

La figure 20 représente, de façon partielle et sous forme de blocs, un exemple d'adaptation possible du circuit de la figure 15 pour obtenir le fonctionnement des figures 18A, 18B, 19A et 19B. Cette modification consiste à utiliser le compte COUNT fourni par le compteur 153 pour le multiplier (multiplieur 160) par un paramètre de conversion du temps (Δt/STEP) stocké en mémoire non volatile (bloc 161, NVM), afin de fournir une valeur de comptage COUNT' modifiée tenant compte des caractéristiques du circuit. Cette valeur COUNT' est fournie au déclencheur 136. Cela revient à appliquer un coefficient de pondération fonction d'une mesure initiale de caractérisation du circuit.

Un avantage de ce mode de réalisation est qu'il ne nécessite aucune modification structurelle du circuit de lecture pour s'adapter à différents circuits de rétention de charges.

La figure 21 représente, de façon très schématique et sous forme de blocs, un mode de réalisation d'un circuit de rétention de charges dans un exemple d'environnement mettant en oeuvre le quatrième aspect de l'invention.

Cette figure est basée, à titre d'exemple, sur le mode de réalisation du circuit de rétention de charges représenté en figure 2. La borne 13 est connectable, par un interrupteur 211 commandé par le signal SET de programmation, à un potentiel V_{PP2} d'initialisation d'une période de décharge. La borne 14 est connectable, par un interrupteur 212 commandé par le signal READ de lecture, à un potentiel V₁₄ de lecture, la tension V₁₉ aux bornes de la source de courant 19 (illustrée par une résistance) fournissant une information représentative du temps écoulé depuis l'initialisation.

Selon un exemple préféré du quatrième aspect de l'invention, l'élément C1 est utilisable également en tant qu'élément de programmation rapide en appliquant des niveaux de tension adaptés pour obtenir une injection ou extraction rapide d'électrons sur le noeud F. Un interrupteur 213 est alors intercalé entre l'électrode 22 de l'élément C1 et une borne d'application d'un potentiel VPP₃ pour forcer une injection ou une extraction de charges sur le noeud F. L'interrupteur 213 est commandé par un signal FLASH SET de programmation rapide. Au repos (lorsqu'il n'applique pas le potentiel VPP₃ sur l'électrode 22), l'interrupteur 213 connecte, au moins fonctionnellement, l'électrode 22 à la masse. En pratique, l'interrupteur 213 peut laisser la borne 22 en l'air. Il suffit qu'il existe, par la structure du circuit, un chemin de décharge du noeud F vers la masse à travers l'élément de fuite C1. C'est en pratique quasiment toujours le cas.

L'exemple décrit en relation avec la figure 21 est particulièrement adapté à un circuit de rétention de charges réalisé à partir de transistors à grille flottante (figures 8A à 12C).

Une telle programmation rapide (relativement rapide par rapport à la programmation normale par l'élément C3) peut servir, par exemple, suite à une détection d'une condition de fonctionnement anormal visant à empêcher la programmation normale du circuit.

Le risque de contraindre le diélectrique de l'élément C1 et de perdre ainsi la reproductibilité des mesures est acceptable car il s'agit d'un cas en principe rare dans la vie du produit. De plus, toute dégradation du diélectrique va dans le sens d'accélérer la décharge, donc de réduire la fenêtre temporelle. Or, c'est le plus souvent l'effet recherché en cas de détection d'un fonctionnement anormal. En particulier, si un tel fonctionnement est prévu en cas de détection d'une tentative de piratage d'un produit, réduire la capacité d'utilisation à chaque détection va dans le sens des protections généralement recherchées.

Selon les applications, la fonction de programmation rapide peut servir, soit pour apporter des charges sur le noeud F et redémarrer une période temporelle, soit à l'inverse pour forcer une décharge rapide du noeud F, par exemple, pour interdire un accès ultérieur à des données protégées par le circuit de rétention de charges.

Le tableau II ci-dessous illustre un mode de mise en oeuvre d'une programmation rapide (FLASH SET) selon le quatrième aspect de l'invention dans une réalisation du circuit de rétention de charges du type de celle illustrée par les figures 8A à 12C. Le tableau II reprend les phases de programmation et de lecture du tableau I décrit précédemment.

**Tableau II**

| | SEL | CG | BL2 | BL3 | BL1 | BL4 | 12 |
|---|---|---|---|---|---|---|---|
| SET | VPP₁ | 0 | HZ | VPP₂ | HZ | HZ | HZ |
| FLASH SET | VPP₁ | 0 | HZ | HZ | VPP₃ | HZ | HZ |
| READ | V_{SEL} | V_{READ} | HZ | HZ | HZ | V₁₄ | 0 |

La programmation rapide FLASH SET consiste à appliquer le potentiel de polarisation VPP₃ (par exemple, égal au niveau VPP₂ qui est disponible) sur la ligne BL1 (figure 8C) alors que toutes les autres lignes de bit BL2 à BL4 sont en état de haute impédance HZ, et un signal CG nul alors que le signal SEL au niveau VPP₁ rend passants les transistors de sélection T1 à T4. La ligne 12 est préférentiellement dans un état de haute impédance HZ.

La programmation rapide tire profit de la faible épaisseur de diélectrique de l'élément C1 par rapport au diélectrique 102 (figure 10B) du transistor de réinitialisation 7 pour accélérer la programmation.

Un avantage de cet aspect de l'invention est de combiner une mesure temporelle suite à des périodes d'absence d'alimentation avec une fonction de programmation rapide en charge ou en décharge.

La présente invention trouve de multiples applications dans tout système où l'on souhaite pouvoir mesurer un temps sur un circuit non alimenté. Un exemple d'application particulier concerne la gestion de droits d'accès à des données ou programmes stockés sur des supports numériques. Dans une telle application, un circuit selon l'invention peut être adjoint au système de mémorisation (clé mémoire ou analogue) non alimenté en permanence, ou être dans un circuit séparé et être réinitialisé par exemple, lors d'un premier chargement des données à protéger.

Un deuxième exemple d'application concerne la mesure d'intervalles temporels entre deux événements quelconques, par exemple, dans des applications de type transactionnel.

Bien entendu, la présente invention est susceptible de diverses variantes et modifications qui apparaîtront à l'homme de l'art. En particulier, la mise en oeuvre pratique du circuit de l'invention à partir des indications fonctionnelles données ci-dessus et des besoins de l'application ne pose pas de difficulté. Par exemple, la programmation pourra n'être accessible qu'une seule fois ou être refaite à chaque mise sous tension selon l'application. De plus, notamment comme elle ne requiert pas d'alimentation permanente, l'invention peut être mise en oeuvre dans des dispositifs sans contact (de type transpondeurs électromagnétiques) qui tirent leur alimentation d'un champ électromagnétique dans lequel ils se trouvent (généré par un terminal).

## Revendications

1. Circuit électronique de rétention de charges pour une mesure temporelle, comportant :
au moins un premier élément capacitif (C1) dont une première électrode (21) est connectée à un noeud flottant (F) ;
au moins un deuxième élément capacitif (C2) dont une première électrode (31) est directement connectée audit noeud flottant (F), le premier élément capacitif présentant une fuite au travers de son espace diélectrique (23), et
au moins un premier transistor (5, 6) à borne de commande isolée et connectée avec ladite borne de commande audit noeud flottant;
**caractérisé en ce que** le deuxième élément capacitif a une capacité de rétention de charges supérieure au premier.

2. Circuit selon la revendication 1, dans lequel la mesure d'une information temporelle est obtenue en évaluant la charge résiduelle du noeud flottant (F) à partir du courant (I₁₄) dans le premier transistor (5, 6).

3. Circuit selon l'une quelconque des revendications 1 ou 2, dans lequel l'épaisseur de l'espace diélectrique du deuxième élément capacitif (C2) est supérieure à celle du premier (C1).

4. Circuit selon l'une quelconque des revendications 1 à 3, dans lequel au moins un troisième élément capacitif (C3, 7) a une première électrode (41) reliée audit noeud flottant (F) et une deuxième électrode (42) connectable à une source de tension.

5. Circuit selon la revendication 4, dans lequel une réinitialisation ou programmation est obtenue en injectant ou extrayant des charges du noeud flottant (F) par l'intermédiaire du troisième élément capacitif (C3, 7).

6. Circuit selon l'une quelconque des revendications 4 et 5, dans lequel l'épaisseur de l'espace diélectrique du troisième élément capacitif (C3, 7) est supérieure à celle du premier (C1) .

7. Circuit selon l'une quelconque des revendications 4 à 6, dans lequel ledit troisième élément capacitif (C3) est formé par un diélectrique entre une grille flottante et la zone active d'un transistor à double grille (7).

8. Circuit selon l'une quelconque des revendications 1 à 7, dans lequel ledit premier transistor (6) est un transistor à grille flottante.

9. Circuit selon la revendication 8 dans son rattachement à l'une quelconque des revendications 4 à 7, dans lequel l'épaisseur de l'espace diélectrique entre la grille flottante et la zone active du premier transistor (6) est supérieure à celle de l'espace diélectrique du troisième élément capacitif (C3, 7).

10. Circuit selon l'une quelconque des revendications 1 à 9, dans lequel la capacité du deuxième élément (C2) conditionne le temps de rétention.

11. Procédé de commande d'un circuit de rétention de charges selon l'une quelconque des revendications 1 à 10, dans lequel une programmation ou initialisation est obtenue en injectant ou extrayant des charges sur le noeud flottant (F).

## Claims

1. An electronic circuit of charge retention for a time measurement, comprising:
at least one first capacitive element (C1) having a first electrode (21) connected to a floating node (F);
at least one second capacitive element (C2) having a first electrode (31) directly connected to said floating node (F), the first capacitive element exhibiting a leakage through its dielectric spacer (23); and
at least one first transistor (5, 6) with an isolated control terminal, connected with said control terminal to said floating node,
**characterized in that** the second capacitive element has a greater charge retention capacitance than the first one.

2. The circuit of claim 1, wherein the measurement of time data is obtained by evaluating the residual charge of the floating node (F) based on the current (I₁₄) in the first transistor (5, 6).

3. The circuit of claim 1 or 2, wherein the thickness of the dielectric spacer of the second capacitive element (C2) is greater than that of the first one (C1).

4. The circuit of any of claims 1 to 3, wherein at least one third capacitive element (C3, 7) has a first electrode (41) connected to said floating node (F) and a second electrode (42) connectable to a voltage source.

5. The circuit of claim 4, wherein a reset or programming is obtained by injecting or extracting charges into or from the floating node (F) via the third capacitive element (C3, 7).

6. The circuit of claim 4 or 5, wherein the thickness of the dielectric spacer of the third capacitive element (C3, 7) is greater than that of the first one (C1).

7. The circuit of any of claims 4 to 6, wherein said third capacitive element (C3) is formed by a dielectric between a floating gate and the active area of a dual-gate transistor (7).

8. The circuit of any of claims 1 to 7, wherein said first transistor (6) is a floating-gate transistor.

9. The circuit of claim 8 as attached to any of claims 4 to 7, wherein the thickness of the dielectric spacer between the floating gate and the active area of the first transistor (6) is greater than that of the dielectric spacer of the third capacitive element (C3, 7).

10. The circuit of any of claims 1 to 9, wherein the capacitance of the second element (C2) conditions the retention time.

11. A method for controlling the charge retention circuit of any of claims 1 to 10, wherein a programming or initialization is obtained by injecting or extracting charges into or from the floating node (F).

## Patentansprüche

1. Ein elektronischer Schaltkreis zur Ladungserhaltung für eine Zeitmessung, der Folgendes aufweist:
wenigstens ein erstes kapazitives Element (C1) mit einer ersten Elektrode (21), die mit einem potentialfreien Knoten (floating node) (F) verbunden ist;
wenigstens einem zweiten kapazitiven Element (C2) mit einer ersten Elektrode (31), die direkt mit dem potentialfreien Knoten (F) verbunden ist, wobei das erste kapazitive Element ein Leckage durch seine dielektrische Zwischenlage (23) aufweist; und
wenigstens einen ersten Transistor (5, 6) mit einem isolierten Steueranschluss, wobei der Steueranschluss mit dem potentialfreien Knoten verbunden ist, **dadurch gekennzeichnet, dass** das zweite kapazitive Element eine größere Ladungserhaltungskapazität aufweist als das erste kapazitive Element.

2. Schaltkreis gemäß Anspruch 1, wobei die Messung der Zeitdaten durch das Auswerten der Restladung des potentialfreien Knotens (F), basierend auf dem Strom (I₁₄) in dem ersten Transistor (5, 6) gewonnen wird.

3. Schaltkreis gemäß Anspruch 1 oder 2, wobei die Dicke der dielektrischen Zwischenschicht des zweiten kapazitiven Elements (C2) größer ist als die Dicke des ersten kapazitiven Elements (C1).

4. Schaltkreis gemäß einem der Ansprüche 1 bis 3, wobei wenigstens ein drittes kapazitives Element (C3, 7) eine erste Elektrode (41) aufweist, die mit dem potentialfreien Knoten (F) verbunden ist und eine zweite Elektrode (42) aufweist, die mit einer Spannungsquelle verbindbar ist.

5. Schaltkreis gemäß Anspruch 4, wobei ein Rücksetzen oder ein Programmieren durch das Einbringen in oder Abführen von Ladung aus dem potentialfreien Knoten (F) über das dritte kapazitive Element (C3, 7) erreicht wird.

6. Schaltkreis gemäß Anspruch 4 oder 5, wobei die Dicke der dielektrischen Zwischenschicht des dritten kapazitiven Elements (C3, 7) größer ist als die des ersten kapazitiven Elements (C1).

7. Schaltkreis gemäß einem der Ansprüche 4 bis 6, wobei das dritte kapazitive Element (C3) durch ein Dielektrikum zwischen einem potentialfreien Knoten und dem aktiven Bereich eines Dual-Gate Transistors (7) gebildet ist.

8. Schaltkreis gemäß einem der Anspruch 1 bis 7, wobei der erste Transistor (6) ein Floating-Gate Transistor ist.

9. Schaltkreis gemäß Anspruch 8 und einem der Ansprüche 4 bis 7, wobei die Dicke der dielektrischen Zwischenschicht zwischen dem potentialfreien Knoten und dem aktiven Bereich des ersten Transistors (6) größer ist als die Dicke der dielektrischen Zwischenschicht des dritten kapazitiven Elements (C3, 7).

10. Schaltkreis gemäß einem der Ansprüche 1 bis 9, wobei die Kapazität des zweiten Elements (C2) die Erhaltungszeit bestimmt.

11. Ein Verfahren zum Steuern des Schaltkreises zur Ladungsrückhaltung gemäß einem der Ansprüche 1 bis 10, wobei eine Programmierung oder eine Initialisierung durch das Einbringen in oder Abführen von Ladung aus dem potentialfreien Knoten (F) erzielt wird.
